(19) Europäisches Patentamt
European Patent Office
Office européen des brevets

(11) **EP 3 907 750 B1**

(12) **EUROPEAN PATENT SPECIFICATION**

(45) Date of publication and mention
of the grant of the patent:
**04.10.2023   Bulletin 2023/40**

(21) Application number: **21167175.5**

(22) Date of filing: **07.04.2021**

(51) International Patent Classification (IPC):
*H01F 27/28* *(2006.01)*   *H05K 1/18* *(2006.01)*
*H01F 27/32* *(2006.01)*

(52) Cooperative Patent Classification (CPC):
**H01F 27/2871; H01F 27/2866; H01F 27/327;**
H05K 1/165; H05K 2201/086; H05K 2201/10265

(54) **WINDING ASSEMBLY AND MAGNETIC ASSEMBLY**

WICKLUNGSANORDNUNG UND MAGNETISCHE ANORDNUNG

ENSEMBLE ENROULEMENT ET ENSEMBLE MAGNÉTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:   **07.05.2020   CN 202020729987 U**

(43) Date of publication of application:
**10.11.2021   Bulletin 2021/45**

(73) Proprietor: **Delta Electronics (Shanghai) Co., Ltd.
Shanghai 201209 (CN)**

(72) Inventors:
• **FU, Qi
SHANGHAI, 201209 (CN)**
• **SONG, Haibin
SHANGHAI, 201209 (CN)**
• **XU, Daofei
SHANGHAI, 201209 (CN)**
• **LU, Zengyi
SHANGHAI, 201209 (CN)**
• **ZHANG, Jinfa
SHANGHAI, 201209 (CN)**

(74) Representative: **Cabinet Beau de Loménie
158, rue de l'Université
75340 Paris Cedex 07 (FR)**

(56) References cited:
**US-A1- 2008 197 960     US-A1- 2008 211 613
US-A1- 2010 253 153     US-A1- 2011 285 215**

## Description

## TECHNICAL FIELD

The disclosure relates to the technical field of power electronics, in particular to a winding assembly and a magnetic assembly.

## BACKGROUND

Recently, the miniaturization, high efficiency and high frequency are the trends of switching power supply, and the application of planar transformers has been widely used. The transformer usually includes a primary coil, a secondary coil and a magnetic core. However, there are some drawbacks for the traditional planar transformer, for example, parasitic capacitor between the primary coil and secondary coil is relatively large, which seriously impact the efficiency of the power converter. Reduction the parasitic capacitor is the key for the application of the planar transformer.

It should be noted that the information disclosed in the above Background section is only used to enhance the understanding of the background of the present disclosure, and therefore may include information that does not constitute the prior art known to those of ordinary skill in the art.

Related technologies are known from the following patent application documents:

US2010253153A1, providing coil units, electronic instruments and the like, which can radiate heat generated in a coil into a space outside a protective member, while the number of components does not increase;

US2008197960A1, disclosing a coil unit, where the coil unit includes a planar coil, a printed circuit board that includes a planar coil placement section that receives the planar coil, a protective sheet that is provided on a transmission side of the planar coil and protects the planar coil, and a magnetic sheet that is provided on a non-transmission side of the planar coil;

US2011285215A1, disclosing a method for manufacturing a module including a planar coil, where the method includes the steps of providing a second resin layer including a magnetic filler on a first resin layer with a built-in chip-type electronic component; providing a planar coil on the second resin layer; and providing a third resin layer including a non-magnetic property so as to coat the planar coil;

US2008211613A1, disclosing a transformer including a first electrical conductor, a second electrical conductor, a circuit board and a core set.

## SUMMARY

The invention is defined by the appended set of claims. According to a first aspect of the present disclosure, there is provided a winding assembly, which includes a first coil and a circuit board, the first coil being embedded inside the circuit board; wherein the first coil comprises a conductive wire with at least one turn, and the height of the conductive wire in a direction perpendicular to the circuit board is not less than the width of the conductive wire in a direction parallel to the circuit board.

The winding assembly further includes at least one flat copper coil disposed on a surface of the circuit board or embedded inside the circuit board, and the at least one flat copper coil is insulated with the first coil.

In some embodiments of the present disclosure, the at least one flat copper coil comprises a first flat copper coil and a second flat copper coil, and the first flat copper coil and the first coil are insulated, and the first coil and the second flat copper coil are insulated.

In some embodiments of the present disclosure, the conductive wire is a flat copper strip.

In some embodiments of the present disclosure, the conductive wire is litz wire.

According to a second aspect of the present disclosure, there is provided a magnetic assembly, which includes a first winding assembly and a magnetic core, the first winding assembly being assembled with the magnetic core; wherein the first winding assembly comprises a first coil and a first circuit board, the first coil being embedded inside the first circuit board, and wherein the first coil comprises a conductive wire with at least one turn, and the height of the conductive wire in a direction perpendicular to the first circuit board is not less than the width of the conductive wire in a direction parallel to the first circuit board.

The first circuit board further comprises at least one flat copper coil disposed on a surface of the first circuit board or embedded inside the first circuit board, and the at least one flat copper coil is insulated with the first coil.

In some embodiments of the present disclosure, the at least one flat copper coil comprises a first flat copper coil and a second flat copper coil, and the first flat copper coil and the first coil are insulated, and the first coil and the second flat copper coil are insulated.

In some embodiments of the present disclosure, the magnetic assembly further includes a second winding assembly assembled with the magnetic core; wherein the second winding assembly comprises a second circuit board, and the second circuit board further comprises at least one flat copper coil disposed on a surface of the second circuit board or embedded inside the second circuit board; wherein the second winding assembly and the first winding assembly are disposed in a stacked manner with each other.

In some embodiments of the present disclosure, the magnetic assembly further includes a third winding assembly assembled with the magnetic core; wherein the third winding assembly comprises a third circuit board, and the third circuit board further comprises at least one other flat copper coil disposed on a surface of the third circuit board or embedded inside the third circuit board; wherein the second winding assembly and the third winding assembly are stacked on the upper and lower sides of the first winding assembly respectively.

In some embodiments of the present disclosure, the magnetic assembly is a transformer, the first coil is a primary winding of the transformer, and the at least one flat copper coil is a secondary winding of the transformer.

In some embodiments of the present disclosure, the magnetic assembly is a transformer, the first coil is a secondary winding of the transformer, and the at least one flat copper coil is a primary winding of the transformer.

In some embodiments of the present disclosure, the magnetic assembly is a transformer, and the at least one flat copper coil is a shielding layer.

In some embodiments of the present disclosure, the magnetic assembly is an inductor.

In some embodiments of the present disclosure, the conductive wire is a flat copper strip or a litz wire.

It should be understood that the above general description and the following detailed description are only exemplary and explanatory, and cannot limit the present disclosure.

## BRIEF DESCRIPTION OF THE DRAWINGS

By describing its exemplary embodiments in detail with reference to the accompanying drawings, the above and other objectives, features and advantages of the present disclosure will become more apparent.

FIG. 1 is a schematic sectional view of a winding assembly according to an example not covered by the appended claims.

FIG. 2 is a perspective schematic diagram of a first coil and a circuit board in the winding assembly shown in FIG. 1.

FIG. 3 is a schematic sectional view of a winding assembly according to an exemplary embodiment of the present disclosure.

FIG. 4 is a stereoscopic schematic diagram of a winding assembly according to an exemplary embodiment of the present disclosure.

FIG. 5 is a schematic sectional view of a winding assembly according to an exemplary embodiment of the present disclosure.

FIG. 6 is an exploded view of a magnetic assembly according to an example not covered by the appended claims.

FIG. 7 is an exploded view of a magnetic assembly according to an exemplary embodiment of the present disclosure.

FIG. 8 is an exploded view of a magnetic assembly according to an exemplary embodiment of the present disclosure.

## DETAILED DESCRIPTION

Exemplary embodiments will now be described more fully with reference to the drawings. However, the exemplary embodiments can be implemented in various forms, and should not be construed as being limited to the examples set forth herein; rather, these embodiments are provided to make the present disclosure more comprehensive and complete, and fully convey the ideas of the exemplary embodiments to those skilled in the art. The drawings are only schematic illustrations of the present disclosure and are not necessarily drawn to scale. The same reference numerals in the drawings indicate the same or similar structures, and thus the detailed description thereof will be omitted.

Furthermore, the described features, structures, or characteristics may be combined in any suitable manner in one or more embodiments. In the following description, numerous specific details are set forth to give a thorough understanding of the embodiments of the present disclosure. However, those skilled in the art will appreciate that the technical solution of the present disclosure may be practiced without one or more of the specific details, or other methods, elements, and the like may be employed. In other instances, well-known structures, methods, or operations are not shown or described in detail to avoid obscuring aspects of the present disclosure.

The terms 'first' and 'second' are only used for descriptive purposes, and cannot be understood as indicating or implying relative importance or implicitly indicating the number of indicated technical features. Thus, the features defined with 'first' and 'second' may explicitly or implicitly include one or more of these features.

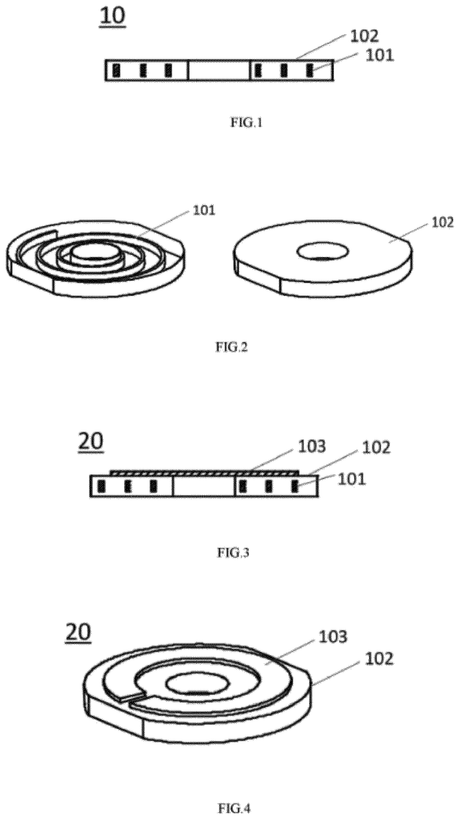

FIG. 1 is a schematic sectional view of a winding assembly according to an example not covered by the appended claims. FIG. 2 is a perspective schematic diagram of a first coil and a circuit board in the winding assembly shown in FIG. 1. As shown in FIG. 1, a winding assembly 10 includes a first coil 101 and a circuit board 102, wherein the first coil 101 includes a conductive wire with at least one turn, and the first coil 101 is embedded inside the circuit board 102, for example a Printed Circuit Board (PCB). The height of the conductive wire in the direction perpendicular to the circuit board is not less than the width of the conductive wire in the direction parallel to the circuit board. In FIG. 1, cross sections of the conductive wire are shown as black rectangular blocks, and the height of the black rectangular block is greater than the width of the black rectangular block. The coil 101 may be formed by vertically winding flat wires.

The first coil 101 may be a single-layer coil, a two-layer coil or a multi-layer coil, and the first coil 101 may include one turn or multiple turns, which is not limited by the present disclosure. In the winding assembly 10 shown in FIG. 1, for example, the first coil 101 includes three turns.

The first type parasitic capacitor in the circuit board can be determined by the following formula:

$$C_1 = \varepsilon \frac{s_1}{d_1}$$

wherein $C_1$ is first type parasitic capacitor; $\varepsilon$ is a dielectric constant, which is determined by the material of the circuit board; $S_1$ is a facing area between the turns of the first coil 101; and $d_1$ is the distance between the turns of the first coil 101. The distance $d_1$ between the turns of the first coil 101 wound vertically is longer, so that the first type parasitic capacitor $C_1$ can be reduced.

In some examples, such as shown in FIG. 2, the conductive wire wound perpendicular to the circuit board 102 may be a flat copper strip embedded inside the circuit board 102, without being exposed to the outside. The height of the flat copper strip in the direction perpendicular to the circuit board 102 is greater than the width of the flat copper strip in the direction parallel to the circuit board 102, referring to cross section of the flat copper strip perpendicular to the circuit board 102.

In some examples, the conductive wire of the first coil 101 may be litz wire, and the cross section perpendicular to the circuit board of the litz wire is substantially circular. Furthermore, the height of the litz wire in the direction perpendicular to the circuit board is roughly equal to the width of the litz wire in the direction parallel to the circuit board. In some embodiments, the first coil 101 can be formed by multiple strands of litz wires having a certain withstand voltage level. In case of a large number of turns, skin effect and proximity effect may be effectively avoided by using litz wire.

The winding assembly 10 may be used as an inductor or a transformer. The transformer may be of any known type, such as a planar transformer. In some embodiments, the first coil 101 may be the primary winding or the secondary winding of the transformer, according to product requirements.

The present disclosure describes how to form and use specific examples, but the principle of the present disclosure is not limited to any details of these examples. On the contrary, based on the teaching of the disclosure of the present disclosure, these principles can be applied to many other embodiments.

According to the present invention, the winding assembly includes at least one flat copper coil disposed on a surface of the circuit board or embedded inside the circuit board. Specifically, FIG. 3 is a schematic sectional view of a winding assembly according to an exemplary embodiment. FIG. 4 is a stereoscopic schematic diagram of a winding assembly according to an exemplary embodiment. As shown in FIG. 3 and FIG. 4, the winding assembly 20 includes a first coil 101 and a circuit board 102, and the first coil 101 is embedded inside the circuit board 102. Furthermore, the circuit board 102 includes one flat copper coil 103, and the flat copper coil 103 is disposed on a surface of the circuit board 102 as shown in FIG. 3. In some other embodiments, the flat copper coil 103 can be embedded inside the circuit board 102. The flat copper coil 103 and the first coil 101 are insulated.

In some embodiments, the flat copper coil 103 and the first coil 101 are insulated by the circuit board 102. In some embodiments, an insulating material is arranged between the flat copper coil 103 and the first coil 101. In other words, the insulating material between the first coil 101 and the flat copper coil 103 may be integrally formed with the circuit board having the same material, or may be manufactured in an independent process.

Furthermore, the first coil 101 may be a single-layer coil, a two-layer coil or a multi-layer coil, and the first coil 101 may include one turn or multiple turns.

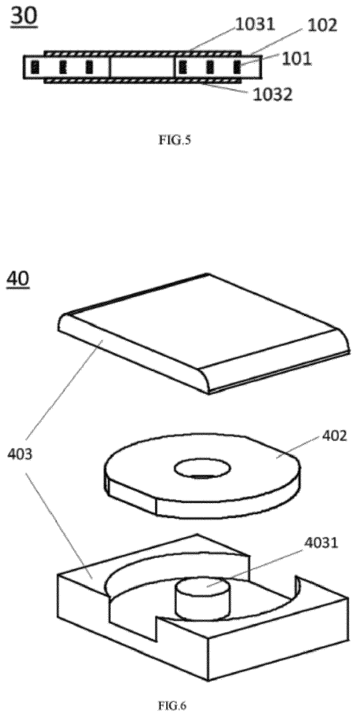

The flat copper coil 103 can be a single-layer flat copper coil, a two-layer flat copper coil or a multi-layer flat copper coil. In case the flat copper coil 103 has two layers, the two layers can be arranged on upper and lower sides of the first coil 101 respectively, as shown in FIG. 5. The flat copper coil 103 can include one turn or multiple turns, which is not limited by the present disclosure.

The second type parasitic capacitor in the circuit board can be determined by the following formula:

$$C_2 = \varepsilon \frac{s_2}{d_2}$$

wherein $C_2$ is second type parasitic capacitor; $\varepsilon$ is a dielectric constant, which is determined by the material of the circuit board; $S_2$ is a facing area between the first coil 101 and the flat copper coil 103; and $d_2$ is the distance between the first coil 101 and the flat copper coil 103.

According to the winding assembly provided by the embodiment of the present disclosure, the width of the conductive wire of the first coil 101 in the direction parallel to the circuit board is less than or equal to the height of the first coil 101 in the direction perpendicular to the circuit board, so that the facing area between the first coil 101 and the flat copper coil 103 can be reduced, thereby leading to a second type parasitic capacitor of the winding assembly which is decreased.

The winding assembly 20 may be a transformer, for example, and the transformer may be of any known type, such as a planar transformer. In some embodiments, the first coil 101 may be the primary winding of the planar transformer and the flat copper coil 103 may be the secondary winding of the planar transformer, according to product requirements. Alternatively, the first coil 101 can also be the secondary winding of the planar transformer, and the flat copper coil 103 can be the primary winding of the planar transformer. In another embodiment, the flat copper coil 103 can also be used as a shielding layer for the primary side or the secondary side of the transformer.

Furthermore, the first coil 101, the flat copper coil 103 and the circuit board 102 are coaxially assembled to form the winding assembly 20. And a projection of the flat copper coil 103 onto a plane where the circuit board 102 is located partially overlaps with a projection of the first coil 101 onto that plane.

According to the winding assembly provided by the embodiment of the present disclosure, the facing area between the first coil 101 and the flat copper coil 103 located at a surface of the circuit board 102 and/or inside of the circuit board 102 can be reduced, thereby leading to a second type parasitic capacitor of the winding assembly which is decreased.

FIG. 5 is a schematic sectional view of a winding assembly according to an exemplary embodiment. As shown in FIG. 5, the winding assembly 30 includes a first coil 101 and a circuit board 102, and the first coil is embedded inside the circuit board 102. Furthermore, the winding assembly 30 includes a first flat copper coil 1031 and a second flat copper coil 1032. The first flat copper coil 1031 and the first coil 101 are insulated, and the first coil 101 and the second flat copper coil 1032 are insulated. As shown in FIG. 5, the first flat copper coil 1031 is disposed on a top surface of the circuit board 102, and the second flat copper coil 1032 is disposed on a bottom surface of the circuit board 102, so that the first flat copper coil 1031 and the second flat copper coil 1032 can be stacked on the upper and lower sides of the first coil 101, respectively.

In some other embodiments, the first flat copper coil 1031 and the second flat copper coil 1032 may be located inside of the circuit board 102

Furthermore, the first coil 101 may be a single-layer first coil, a two-layer first coil or a multi-layer first coil, and the first coil 101 may include one turn or multiple turns. The first flat copper coil 1031 and the second flat copper coil 1032 can include one turn or multiple turns, which are not limited by the present disclosure.

In some embodiments, the insulating material between the first flat copper coil 1031 and the first coil 101 or between the second flat copper coil 1032 and the first coil 101 can be integrally formed with the circuit board 102 having the same material. That is, the first flat copper coil 1031, the second flat copper coil 1032 and the first coil 101 can be insulated by the circuit board 102. In a variant, the insulating material between the first flat copper coil 1031 and the first coil 101 or between the second flat copper coil 1032 and the first coil 101 can be made in an independent process and then disposed in the circuit board 102.

In some embodiments, the first flat copper coil 1031 and the second flat copper coil 1032 may be connected electrically by vias.

The winding assembly 30 may be used in a transformer, for example, and the transformer may be of any known type, such as a planar transformer. In some embodiments, the first coil 101 can be the primary winding of the planar transformer, and the first flat copper coil 1031 and the second flat copper coil 1032 can be the secondary winding of the planar transformer, according to product requirements. Alternatively, the first coil 101 can be the secondary winding of the planar transformer, and the first flat copper coil 1031 and the second flat copper coil 1032 can be the primary winding of the planar transformer. In another embodiment, the flat copper coil 1031 and/or the flat copper coil 1032 can also be used as a shielding layer of the primary side or of the secondary side of the transformer.

In some embodiments, the first coil 101, the first flat copper coil 1031, the second flat copper coil 1032 and the circuit board 102 are coaxially assembled to form the winding assembly 30. In some embodiments, projections of the first flat copper coil 1031 and the second flat copper coil 1032 onto a plane where the circuit board 102 is located partially overlap with a projection of the first coil 101 onto that plane. That is, a projection of the first flat copper coil 1031 onto a plane where the circuit board 102 is located partially overlaps with a projection of the first coil 101 onto that plane, and at the same time a projection of the second flat copper coil 1032 onto that plane also partially overlaps with a projection of the first coil 101 onto that plane.

According to the winding assembly provided by the embodiment of the present disclosure, the facing area between the first coil 101 and the first flat copper coil 1031, and the facing area between the first coil 101 and the second flat copper coil 1032 can be reduced, thereby leading to a parasitic capacitor of the winding assembly which is decreased.

FIG. 6 is an exploded view of a magnetic assembly according to an example not covered by the appended claims. As shown in FIG. 6, the magnetic assembly 40 includes a first winding assembly and a magnetic core 403. The first winding assembly includes a first coil (not shown in FIG. 6) and a first circuit board 402. The first coil includes a conductive wire with at least one turn, the first coil is embedded inside the first circuit board 402, and the height of the conductive wire in the direction perpendicular to the first circuit board 402 is not less than the width of the conductive wire in the direction parallel to the first circuit board 402. A through hole is provided on the first circuit board 402, and the middle leg 4031 of the magnetic core 403 passes through the through hole, and the first circuit board 402 is assembled with the magnetic core 403.

Furthermore, the first coil may be a single-layer coil, a two-layer coil or a multi-layer coil, and the first coil may include one turn or multiple turns, which is not limited by the present disclosure.

In some examples, the conductive wire may be a flat copper strip, and the height of the flat copper strip in the direction perpendicular to the circuit board 402 is larger than the width of the flat copper strip in the direction parallel to the circuit board 402.

In some examples, the conductive wire is litz wire with at least one turn. The cross section perpendicular to the circuit board of the litz wire is substantially circular. Furthermore, the height of the litz wire in the direction perpendicular to the circuit board is roughly equal to the width of the litz wire in the direction parallel to the circuit board. In some embodiments, the first coil can be formed by multiple strands of litz wires having a certain withstand voltage level. The cross section of the first coil perpendicular to the circuit board is substantially circular. Furthermore, the height of the first coil in the direction perpendicular to the circuit board is proximately equal to the width in the direction parallel to the circuit board. In case of a large number of turns, skin effect and proximity effect may be effectively avoided by the use of litz wire.

The magnetic assembly 40 may be, for example, an inductor or a transformer. The transformer may be of any known type, such as a planar transformer. In some embodiments, the first coil may be the primary winding or the secondary winding of the planar transformer according to product requirements. In some embodiments, the magnetic assembly is an inductor.

The magnetic core 403 may be made of, for example, a magnetic metal oxide composed of a mixture of iron oxides. For example, the magnetic core 403 can be made of manganese-zinc ferrite materials and nickel-zinc ferrite materials. The magnetic core 403 can be of any suitable shape, for example, an 'E'-shaped magnetic core and so on.

The first coil surrounds the middle leg 4031 of the magnetic core 403. The magnetic core 403, the first circuit board 402 and the first coil are assembled to form the magnetic assembly 40.

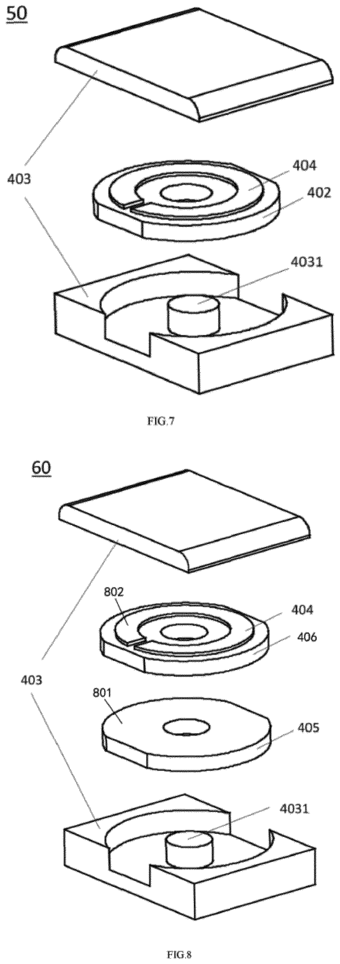

FIG. 7 is an exploded view of a magnetic assembly according to an exemplary embodiment. As shown in FIG. 7, the magnetic assembly 50 includes a first winding assembly and a magnetic core 403. The first winding assembly includes a first coil (not shown) and a first circuit board 402. The first coil includes conductive wire with at least one turn, the first coil is embedded inside the first circuit board 402, and the height of the conductive wire in the direction perpendicular to the first circuit board 402 is not less than the width of the conductive wire in the direction parallel to the first circuit board 402. The circuit board 402 further includes at least one flat copper coil 404, and the at least one flat copper coil 404 is disposed on the surface of the first circuit board 402 or embedded inside the first circuit board 402. Furthermore, the at least one flat copper coil 404 and the first coil are insulated.

In some embodiments, the magnetic assembly 50 is a transformer, and the transformer can be of any known type, such as a planar transformer; the first coil is the primary winding of the planar transformer, and the flat copper coil 404 is the secondary winding of the planar transformer. In some embodiments, the first coil is the secondary winding of the planar transformer, and the flat copper coil 404 is the primary winding of the planar transformer.

In some embodiments, a projection of the flat copper coil 404 onto a plane where the first circuit board 402 is located partially overlaps with a projection of the first coil onto that plane.

The magnetic core 403 may be made of, for example, a magnetic metal oxide composed of a mixture of iron oxides. For example, the magnetic core 403 can be made of manganese-zinc ferrite materials and nickel-zinc ferrite materials. The magnetic core 403 can be of any suitable shape, for example, an 'E'-shaped magnetic core and so on.

The first coil surrounds the middle leg 4031 of the magnetic core 403, and the flat copper coil 404 surrounds the middle leg 4031 of the magnetic core 403. According to the magnetic assembly provided by the embodiment of the present disclosure, the facing area between the first coil and the flat copper coil 404 located at a surface of the circuit board 402 and/or inside of the circuit board 402 can be reduced, thereby leading to a parasitic capacitor of the winding assembly which is reduced.

FIG. 8 is an exploded view of a magnetic assembly according to an exemplary embodiment. As shown in FIG. 8, the magnetic assembly 60 includes a first winding assembly 801, a second winding assembly 802, and a magnetic core 403. The first winding assembly 801 includes a first coil (not shown) and a first circuit board 405. The first coil includes conductive wire with at least one turn, the first coil is embedded inside the first circuit board 405, and the height of the conductive wire in the direction perpendicular to the first circuit board 405 is not less than the width of the conductive wire in the direction parallel to the first circuit board 405. The second winding assembly 802 includes a second circuit board 406, and the second circuit board 406 also includes a flat copper coil 404, which is arranged over a surface of the second circuit board 406 or embedded inside the second circuit board 406, wherein the second winding assembly 802 and the first winding assembly 801 are disposed in a manner stacked with each other. The second winding assembly 802, the first winding assembly 801 and the magnetic core 403 are assembled together.

In some embodiments, the magnetic assembly 60 further includes a third winding assembly, and the second winding assembly and the third winding assembly are disposed on the upper and lower sides of the first winding assembly respectively in a stacked manner. There is no limit on the number of the second winding assembly and the third winding assembly in the present disclosure.

In some embodiments, the magnetic assembly 60 is a transformer, and the transformer can be any known type, such as a planar transformer; the first coil is the primary winding of the planar transformer, and the flat copper coil 404 is the secondary winding of the planar transformer. In some embodiments, the first coil is the secondary winding of the planar transformer, and the flat copper coil 404 is the primary winding of the planar transformer.

In some embodiments, a projection of the flat copper coil 404 onto a plane where the first circuit board 405 is located partially overlaps with a projection of the first coil onto that plane.

The magnetic core 403 may be made of, for example, a magnetic metal oxide composed of a mixture of iron oxides. For example, the magnetic core 403 can be made of manganese-zinc ferrite materials and nickel-zinc ferrite materials. The magnetic core 403 can be any suitable shape, for example, an 'E'-shaped magnetic core and so on.

Furthermore, the first coil surrounds the middle leg 4031 of the magnetic core 403, and the flat copper coil 404 surrounds the middle leg 4031 of the magnetic core 403.

According to the magnetic assembly provided by the embodiment of the present disclosure, the facing area between the first coil and the flat copper coil 404 located at the surface of the second circuit board 406 and/or inside of the second circuit board 406 is reduced, thereby reducing the parasitic capacitance of the magnetic assembly.

The exemplary embodiments of the present disclosure are specifically shown and described above. It should be understood that the present disclosure is not limited to the detailed structure, arrangement or implementation method described here; on the contrary, the present disclosure intends to be limited only by the appended claims.

**Claims**

1. A winding assembly (10), comprising:

   a first coil (101) and a circuit board (102), the first coil (101) being embedded inside the circuit board (102); wherein the first coil (101) comprises a conductive wire with at least one turn, and the height of the conductive wire in a direction perpendicular to the circuit board (102) is not less than the width of the conductive wire in a direction parallel to the circuit board (102), wherein the winding assembly (10) further comprises at least one flat copper coil (103) disposed on a surface of the circuit board (102) or embedded inside the circuit board (102), and the at least one flat copper coil (103) is insulated with the first coil (101).

2. The winding assembly (10) according to claim1, wherein the at least one flat copper coil (103) comprises a first flat copper coil (1031) and a second flat copper coil (1032), and the first flat copper coil (1031) and the first coil (101) are insulated, and the first coil (101) and the second flat copper coil (1032) are insulated.

3. The winding assembly (10) according to claim 1 or 2, wherein the conductive wire is a flat copper strip.

4. The winding assembly (10) according to claim 1 or 2, wherein the conductive wire is litz wire.

5. A magnetic assembly (50, 60), comprising:

   a first winding assembly (801) and a magnetic core (403), the first winding assembly (801) being assembled with the magnetic core (403); wherein the first winding assembly (801) comprises a first coil and a first circuit board (402, 405), the first coil being embedded inside the first circuit board (402, 405), and wherein the first coil comprises a conductive wire with at least one turn, and the height of the conductive wire in a direction perpendicular to the first circuit board (402, 405) is not less than the width of the conductive wire in a direction parallel to the first circuit board (402, 405), wherein the first circuit board (402, 405) further comprises at least one flat copper coil (404) disposed on a surface of the first circuit board (402, 405) or embedded inside the first circuit board (402, 405), and the at least one flat copper coil (404) is insulated with the first coil.

6. The winding assembly (50, 60) according to claim 5, wherein the at least one flat copper coil (404) comprises a first flat copper coil (1031) and a second flat copper coil (1032), and the first flat copper coil (1031) and the first coil are insulated, and the first coil and the second flat copper coil (1032) are insulated.

7. The magnetic assembly (50, 60) according to claim 5 or 6, further comprising a second winding assembly (802) assembled with the magnetic core (403); wherein, the second winding assembly (802) comprises a second circuit board (406), and the second circuit board (406) further comprises at least one flat copper coil (404) disposed on a surface of the second circuit board (406) or embedded inside the second circuit board (406); wherein the second winding assembly (802) and the first winding assembly (801) are disposed in a stacked manner with each other.

8. The magnetic assembly (50, 60) according to claim 7, further comprising a third winding assembly assembled with the magnetic core (403); wherein, the third winding assembly comprises a third circuit board, and the third circuit board further comprises at least one other flat copper coil (404) disposed on a surface of the third circuit board or embedded inside the third circuit board; wherein the second winding assembly (802) and the third winding assembly are stacked on upper and lower sides of the first winding assembly (801) respectively.

9. The magnetic assembly (50, 60) according to one of claims 5 to 8, wherein the magnetic assembly (50, 60) is a transformer, the first coil is a primary winding of the transformer, and the at least one flat copper coil (404) is a secondary winding of the transformer.

10. The magnetic assembly (50, 60) according to one of claims 5 to 8, wherein the magnetic assembly (50, 60) is a transformer, the first coil is a secondary winding of the transformer, and the at least one flat copper coil (404) is a primary winding of the transformer.

11. The magnetic assembly (50, 60) according to one of claims 5 to 8, wherein the magnetic assembly (50, 60) is a transformer, and the at least one flat copper coil (404) is a shielding layer.

12. The magnetic assembly (50, 60) according to one of claims 5 to 8, wherein the magnetic assembly (50, 60) is an inductor.

13. The winding assembly (50, 60) according to one of claims 5 to 8, wherein the conductive wire is a flat copper strip or a litz wire.

**Patentansprüche**

1. Wicklungsanordnung (10), umfassend:

   eine erste Spule (101) und eine Leiterplatte (102), wobei die erste Spule (101) im Inneren der Leiterplatte (102) eingebettet ist, wobei die erste Spule (101) einen leitfähigen Draht mit mindestens einer Windung umfasst und die Höhe des leitfähigen Drahtes in einer Richtung senkrecht zu der Leiterplatte (102) nicht kleiner als die Breite des leitfähigen Drahtes in einer Richtung parallel zu der Leiterplatte (102) ist, wobei die Wicklungsanordnung (10) ferner mindestens eine flache Kupferspule (103) umfasst, die auf einer Oberfläche der Leiterplatte (102) angeordnet ist oder im Inneren der Leiterplatte (102) eingebettet ist, und die mindestens eine flache Kupferspule (103) mit der ersten Spule (101) isoliert ist.

2. Wicklungsanordnung (10) nach Anspruch 1, wobei die mindestens eine flache Kupferspule (103) eine erste flache Kupferspule (1031) und eine zweite flache Kupferspule (1032) umfasst und die erste flache Kupferspule (1031) und die erste Spule (101) isoliert sind und die erste Spule (101) und die zweite flache Kupferspule (1032) isoliert sind.

3. Wicklungsanordnung (10) nach Anspruch 1 oder 2, wobei der leitfähige Draht ein flacher Kupferstreifen ist.

4. Wicklungsanordnung (10) nach Anspruch 1 oder 2, wobei der leitfähige Draht eine Litze ist.

5. Magnetische Anordnung (50, 60), umfassend:

   eine erste Wicklungsanordnung (801) und einen magnetischen Kern (403), wobei die erste Wicklungsanordnung (801) mit dem magnetischen Kern (403) zusammengebaut ist, wobei die erste Wicklungsanordnung (801) eine erste Spule und eine erste Leiterplatte (402, 405) umfasst, wobei die erste Spule im Inneren der ersten Leiterplatte (402, 405) eingebettet ist, und wobei die erste Spule einen leitfähigen Draht mit mindestens einer Windung umfasst und die Höhe des leitfähigen Drahtes in einer Richtung senkrecht zu der ersten Leiterplatte (402, 405) nicht kleiner als die Breite des leitfähigen Drahtes in einer Richtung parallel zu der ersten Leiterplatte (402, 405) ist, wobei die erste Leiterplatte (402, 405) ferner mindestens eine flache Kupferspule (404) umfasst, die auf einer Oberfläche der ersten Leiterplatte (402, 405) angeordnet ist oder im Inneren der ersten Leiterplatte (402, 405) eingebettet ist und die mindestens eine flache Kupferspule (404) mit der ersten Spule isoliert ist.

6. Wicklungsanordnung (50, 60) nach Anspruch 5, wobei die mindestens eine flache Kupferspule (404) eine erste flache Kupferspule (1031) und eine zweite flache Kupferspule (1032) umfasst und die erste flache Kupferspule (1031) und die erste Spule isoliert sind und die erste Spule und die zweite flache Kupferspule (1032) isoliert sind.

7. Magnetische Anordnung (50, 60) nach Anspruch 5 oder 6, ferner umfassend eine zweite Wicklungsanordnung (802), die mit dem magnetischen Kern (403) zusammengebaut sind, wobei die zweite Wicklungsanordnung (802) eine zweite Leiterplatte (406) umfasst und die zweite Leiterplatte (406) ferner mindestens eine flache Kupferspule (404) umfasst, die auf einer Oberfläche der zweiten Leiterplatte (406) angeordnet ist oder im Inneren der zweiten Leiterplatte (406) eingebettet ist, wobei die zweite Wicklungsanordnung (802) und die erste Wicklungsanordnung (801) in einer aufeinandergestapelten Weise angeordnet sind.

8. Magnetische Anordnung (50, 60) nach Anspruch 7, ferner umfassend eine dritte Wicklungsanordnung, die mit dem magnetischen Kern (403) zusammengebaut ist, wobei die dritte Wicklungsanordnung eine dritte Leiterplatte umfasst und die dritte Leiterplatte ferner mindestens eine andere flache Kupferspule (404) umfasst, die auf einer Oberfläche der dritten Leiterplatte angeordnet ist oder im Inneren der dritten Leiterplatte eingebettet ist, wobei die zweite Wicklungsanordnung (802) und die dritte Wicklungsanordnung auf einer Ober- bzw. einer Unterseite der ersten Wicklungsanordnung (801) gestapelt sind.

9. Magnetische Anordnung (50, 60) nach einem der Ansprüche 5 bis 8, wobei die magnetische Anordnung (50, 60) ein Transformator ist, die erste Spule eine Primärwicklung des Transformators ist und die mindestens eine flache Kupferspule (404) eine Sekundärwicklung des Transformators ist.

10. Magnetische Anordnung (50, 60) nach einem der Ansprüche 5 bis 8, wobei die magnetische Anordnung (50, 60) ein Transformator ist, die erste Spule eine Sekundärwicklung des Transformators ist und die mindestens eine flache Kupferspule (404) eine Primärwicklung des Transformators ist.

11. Magnetische Anordnung (50, 60) nach einem der Ansprüche 5 bis 8, wobei die magnetische Anordnung (50, 60) ein Transformator ist und die mindestens eine flache Kupferspule (404) eine Schutzschicht ist.

12. Magnetische Anordnung (50, 60) nach einem der Ansprüche 5 bis 8, wobei die magnetische Anordnung (50, 60) ein Induktor ist.

13. Wicklungsanordnung (50, 60) nach einem der Ansprüche 5 bis 8, wobei der leitfähige Draht ein flacher Kupferstreifen oder eine Litze ist.

**Revendications**

1. Ensemble enroulement (10), comprenant :

    une première bobine (101) et une carte de circuits (102), la première bobine (101) étant incorporée à l'intérieur de la carte de circuits (102) ; dans lequel la première bobine (101) comprend un fil conducteur ayant au moins une spire, et la hauteur du fil conducteur dans une direction perpendiculaire à la carte de circuits (102) n'est pas inférieure à la largeur du fil conducteur dans une direction parallèle à la carte de circuits (102),
    dans lequel l'ensemble enroulement (10) comprend en outre au moins une bobine de cuivre plate (103) disposée sur une surface de la carte de circuits (102) ou incorporée à l'intérieur de la carte de circuits (102), et l'au moins une bobine de cuivre plate (103) est isolée avec la première bobine (101).

2. Ensemble enroulement (10) selon la revendication 1, dans lequel l'au moins une bobine de cuivre plate (103) comprend une première bobine de cuivre plate (1031) et une seconde bobine de cuivre plate (1032), et la première bobine de cuivre plate (1031) et la première bobine (101) sont isolées, et la première bobine (101) et la seconde bobine de cuivre plate (1032) sont isolées.

3. Ensemble enroulement (10) selon la revendication 1 ou 2, dans lequel le fil conducteur est une bande de cuivre plate.

4. Ensemble enroulement (10) selon la revendication 1 ou 2, dans lequel le fil conducteur est un fil divisé.

5. Ensemble magnétique (50, 60), comprenant :

    un premier ensemble enroulement (801) et un noyau magnétique (403), le premier ensemble enroulement (801) étant assemblé avec le noyau magnétique (403) ; dans lequel le premier ensemble enroulement (801) comprend une première bobine et une première carte de circuits (402, 405), la première bobine étant incorporée à l'intérieur de la première carte de circuits (402, 405), et dans lequel la première bobine comprend un fil conducteur ayant au moins une spire, et la hauteur du fil conducteur dans une direction perpendiculaire à la première carte de circuits (402, 405) n'est pas inférieure à la largeur du fil conducteur dans une direction parallèle à la première carte de circuits (402, 405), dans lequel la première carte de circuits (402, 405) comprend en outre au moins une bobine de cuivre plate (404) disposée sur une surface de la première carte de circuits (402, 405) ou incorporée à l'intérieur de la première carte de circuits (402, 405), et l'au moins une bobine de cuivre plate (404) est isolée avec la première bobine.

6. Ensemble enroulement (50, 60) selon la revendication 5, dans lequel l'au moins une bobine de cuivre plate (404) comprend une première bobine de cuivre plate (1031) et une seconde bobine de cuivre plate (1032), et la première bobine de cuivre plate (1031) et la première bobine sont isolées, et la première bobine et la seconde bobine de cuivre plate (1032) sont isolées.

7. Ensemble magnétique (50, 60) selon la revendication 5 ou 6, comprenant en outre un deuxième ensemble enroulement (802) assemblé avec le noyau magnétique (403) ; dans lequel le deuxième ensemble enroulement (802) comprend une deuxième carte de circuits (406), et la deuxième carte de circuits (406) comprend en outre au moins une bobine de cuivre plate (404) disposée sur une surface de la deuxième carte de circuits (406) ou incorporée à l'intérieur de la deuxième carte de circuits (406) ; dans lequel le deuxième ensemble enroulement (802) et le premier ensemble enroulement (801) sont disposés d'une manière empilée l'un avec l'autre.

8. Ensemble magnétique (50, 60) selon la revendication 7, comprenant en outre un troisième ensemble enroulement assemblé avec le noyau magnétique (403) ; dans lequel le troisième ensemble enroulement comprend une troisième carte de circuits, et la troisième carte de circuits comprend en outre au moins une autre bobine de cuivre plate (404) disposée sur une surface de la troisième carte de circuits ou incorporée à l'intérieur de la troisième carte de circuits ; dans lequel le deuxième ensemble enroulement (802) et le troisième ensemble enroulement sont empilés sur des côtés supérieur et inférieur du premier ensemble enroulement (801) respectivement.

9. Ensemble magnétique (50, 60) selon l'une des revendications 5 à 8, dans lequel l'ensemble magnétique (50, 60) est un transformateur, la première bobine est un enroulement primaire du transformateur, et l'au moins une bobine de cuivre plate (404) est un enroulement secondaire du transformateur.

10. Ensemble magnétique (50, 60) selon l'une des revendications 5 à 8, dans lequel l'ensemble magnétique (50, 60) est un transformateur, la première bobine est un enroulement secondaire du transformateur, et l'au moins une bobine de cuivre plate (404) est un enroulement primaire du transformateur.

11. Ensemble magnétique (50, 60) selon l'une des revendications 5 à 8, dans lequel l'ensemble magnétique (50, 60) est un transformateur, et l'au moins une bobine de cuivre plate (404) est une couche de blindage.

12. Ensemble magnétique (50, 60) selon l'une des revendications 5 à 8, dans lequel l'ensemble magnétique (50, 60) est un inducteur.

13. Ensemble enroulement (50, 60) selon l'une des revendications 5 à 8, dans lequel le fil conducteur est une bande de cuivre plate ou un fil divisé.

10

102

101

FIG.1

101

102

FIG.2

20

103 102

101

FIG.3

20

103

102

FIG.4

30

1031  102

101

1032

FIG.5

40

403

402

4031

FIG.6

50

404

402

403

4031

FIG.7

60

802

404

406

403

801

405

4031

FIG.8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010253153 A1
- US 2008197960 A1
- US 2011285215 A1
- US 2008211613 A1